# EUROPÄISCHE PATENTSCHRIFT

(11) **EP 0 847 593 B1**
(45) Veröffentlichungstag und Bekanntmachung des Hinweises auf die Patenterteilung: **12.12.2001**
(21) Anmeldenummer: 96931749.4
(22) Anmeldetag: 13.08.1996
(51) Int. Cl.: H01L 21/822, H01L 21/8247, H01L 27/06

(54) **VERFAHREN ZUR HERSTELLUNG EINER EEPROM-HALBLEITERSTRUKTUR**
METHOD OF PRODUCING AN EEPROM SEMICONDUCTOR STRUCTURE
PROCEDE POUR PRODUIRE UNE STRUCTURE SEMI-CONDUCTRICE EEPROM

(30) Priorität: 28.08.1995 DE 19531629
(43) Veröffentlichungstag der Anmeldung: 17.06.1998
(73) Patentinhaber: Infineon Technologies AG, 81669 München (DE)
(72) Erfinder: TEMPEL, Georg, D-81927 München (DE)
(74) Vertreter: Fischer, Volker, Dipl.-Ing.
(86) Internationale Anmeldenummer: DE9601505
(87) Internationale Veröffentlichungsnummer: WO9708747

(56) Entgegenhaltungen:
- EP-A- 0 152 625
- EP-A- 0 435 534
- US-A- 4 682 402

## Beschreibung

Die Erfindung betrifft ein Verfahren zur Herstellung einer EEPROM-Halbleiterstruktur mit einem Widerstand, einem Dünnfilmtransistor, einem Kondensator und einem Transistor.

In solchen Halbleiterstrukturen tritt häufig das Problem auf, daß bei Verwendung einer CMOS-Schaltung negative Spannungen auf einem Chip mit p-Substrat geschaltet werden müssen, wobei das Substrat auf einem Nullpotential zu halten ist. Umgekehrt ergibt sich das gleiche Problem bei positiven Spannungen, die auf einem n-Substrat geschaltet werden müssen.

In manchen Anwendungen kann dieses Problem durch die Einführung einer Substratvorspannung gelöst werden. Bei Verwendung eines p-Substrats wird das Substratpotential in negativer Richtung verschoben, wodurch die Draindioden des NMOS in einem CMOS-Inverter nur positiv gegenüber dem Substrat vorgespannt und daher in Sperrichtung betrieben werden. Nachteilig ist dabei die höhere Gateoxidbelastung durch die additive negative Substratvorspannung. Die elektrischen Eigenschaften wie NMOS-Einsatzspannung und damit Drainstrom und Performance sind von der Substratspannung abhängig. Außerdem muß die negative Spannung auf dem Chip generiert werden.

Ist eine negative Polung des Substrats nicht zulässig, dann kann man die NMOS-Transistoren, welche die negative Spannung schalten, in eine isolierte p-Wanne setzen. Die Isolation erreicht man durch eine tiefere n-Wanne, die die p-Wanne vollständig umgibt und bei gleicher negativer Wannenvorspannung zum Substrat gesperrt ist. Bei Verwendung eines n-Substrats muß jeweils der entgegengesetzte Leitungstyp verwendet werden. Die Herstellung einer solchen zusätzlichen, isolierenden Wanne führt jedoch zu einem aufwendigen Gesamtprozeß, bei dem eine Hochenergie-Implantation notwendig ist.

In vielen Prozessen, in denen das oben beschriebene Problem auftritt, wird generell neben der Transistorpolyebene eine zusätzliche Polyebene und ein Interpolydielektrikum prozessiert. Exemplarisch seien hier Analog- und Speicherprozesse genannt.

In der EP 0435 534 A2 ist ein Verfahren zur Herstellung eines IC beschrieben, bei dem erste und zweite Bereiche auf Siliziumdioxid auf einem Halbleitersubstrat gebildet werden. Diese Bereiche umfassen eine Polysiliziumschicht, eine Isolationsschicht und eine weitere Polysiliziumschicht. In dem zweiten Bereich werden die beiden letztgenannten Schichten entfernt und eine zweite Isolationsschicht aufgebracht. Danach wird eine dritte Polysiliziumschicht abgeschieden. Der erste Bereich wird so als EPROM-Zelle ausgebildet, während der zweite Bereich einen Kondensator bildet.

In der US 4,682,402 ist ein Halbleiterbauelement beschrieben, das ein Widerstandselement aus einer ersten Polysiliziumschicht und aus Polysiliziuminseln einer strukturierten zweiten Polysiliziumschicht auf Endabschnitten der ersten Polysiliziumschicht umfasst. Der Widerstandswert wird durch einen zentralen Bereich zwischen diesen Endabschnitten bestimmt.

In der EP 0 152 625 A2 ist ein Halbleiterbauelement beschrieben, das Polysiliziumschichten zur gleichzeitigen Herstellung komplementärer FETs aufweist.

Der Erfindung liegt die Aufgabe zugrunde, ein Verfahren zur Herstellung einer EEPROM-Halbleiterstruktur, mit der sich negative Spannungen auf einem p-Substrat bzw. positive Spannungen auf einem n-Substrat schalten lassen, zu schaffen, welches besonders einfach und mit wenigen Prozeßschritten durchführbar ist.

Die Lösung dieser Aufgabe erfolgt gemäß den Merkmalen des Anspruchs 1. Vorteilhafte Weiterbildungen sind in den Unteransprüchen beschrieben.

Nach dem Grundgedanken der Erfindung wird auf einem Halbleitersubstrat in einem Teilbereich eine Feldoxidschicht und in einem zweiten Teilbereich ein Gateoxid erzeugt. Durch Abscheidung einer ersten Polysiliziumschicht und anschließende Strukturierung werden auf dem Feldoxid Siliziumbereiche für den Widerstand, den Dünnfilmtransistor, Speicher- bzw. Floating-Gates der EEPROM-Zelle und den Kondensator geschaffen. Auf dem Gateoxid wird dabei gleichzeitig eine Siliziumstruktur für den Speichertransistor erzeugt. Die Siliziumbereiche für den Widerstand und den Dünnfilmtransistor werden mit einer Maskentechnik abgedeckt, und die Siliziumstrukturen für den Kondensator und den Transistor werden mit Atomen oder Ionen eines Leitungstyps dotiert. Anschließend wird die Maske entfernt und im Bereich der Siliziumstrukturen des Dünnfilmtransistors, des Kondensators und des Transistors wird ein Interpolydielektrikum prozessiert und darauf in einem weiteren Schritt eine zweite Polysiliziumschicht abgeschieden, wobei gleichzeitig für den Transistor eine zweite Siliziumstruktur erzeugt wird. Danach werden der Dünnfilmtransistor und der Kondensator mit einer Maskentechnik abgedeckt und mit einer zweiten Implantation im Bereich des Transistors LDD-Implantationen durchgeführt und gleichzeitig der Widerstand dotiert. Die dabei verwendete Maske wird entfernt und im mittleren Bereich des Widerstands wird eine neue Maske erzeugt und unter Verwendung dieser Maske eine dritte Implantation zur Source/Drain-Implantation mit Dotieratomen oder -ionen vom gleichen Leitungstyp durchgeführt, wobei gleichzeitig die äußeren Bereiche der Siliziumstrukturen im Bereich des Widerstands und des Dünnfilmtransistors dotiert werden. Auf diese Weise erhält man durch den erfindungsgemäßen Gesamtherstellungsprozeß der EEPROM-Zelle gleichzeitig einen Analogwiderstand, einen Dünnfilmtransistor, einen Kondensator und einen Transistor.

Bei Verwendung eines n-Substrats werden die Implantationen mit Dotieratomen oder -ionen vom p-Leitungstyp durchgeführt. Im Falle eines p-Substrats müssen Ionen oder Atome vom n-Leitungstyp bei den Implantationen verwendet werden und man erhält die entgegengesetzten Typen der Transistoren und Wannen.

Ein weiterer Vorteil liegt darin, daß sich der Dünnfilmtransistor im wesentlichen ohne zusätzlichen Maskenaufwand in einen konventionellen Analog-CMOS-Prozeß integrieren läßt. Dies ist durch Angleichung der Dicken des Interpolydielektrikums und der ersten Polysiliziumschicht und der Dosis der LDD-Implantation möglich.

Der im erfindungsgemäßen Gesamtprozeß erzeugte Dünnfilmtransistor ist durch ein dickes Oxid vom Substrat isoliert und wirkt zusammen mit dem Transistor als modifizierter CMOS-Inverter. Durch diesen erfindungsgemäß erzeugten Inverter besteht auch die Möglichkeit, negative Spannungen auf einem Chip mit p-Substrat zu schalten. Bei Verwendung eines n-Substrats ergibt sich umgekehrt die Möglichkeit, positive Spannungen zu schalten. Auf diese Weise läßt sich einfach eine Schaltung für negative Pegel bereitstellen, die ohne großen Aufwand, wie beispielsweise durch Erzeugung der eingangs beschriebenen tieferen, entgegengesetzt dotierten Wannen, hergestellt werden kann (Triple-well-Prozeßl.

In einer Weiterbildung der Erfindung kann auch ein symmetrischer TFT-Inverter aufgebaut werden. Dabei würde also der hier beschriebene konventionelle Transistor auch in Form eines zusätzlichen Dünnfilmtransistors hergestellt werden.

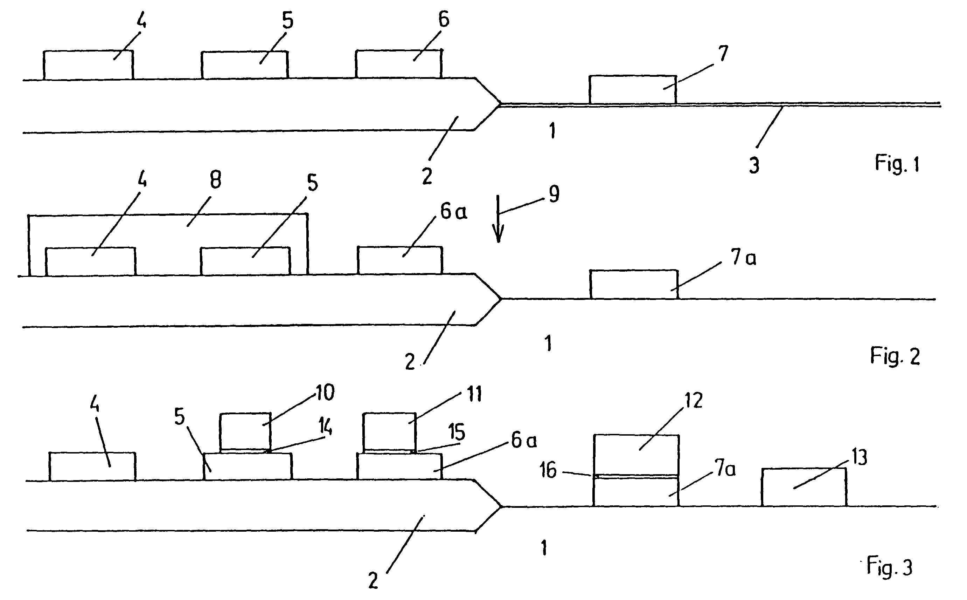

Nachfolgend wird das erfindungsgemäße Verfahren anhand einer Zeichnung weiter erläutert. Im einzelnen zeigen die schematischen Darstellungen in den Figuren 1 bis 5 den Aufbau der gesamten EEPROM-Zelle bei verschiedenen Verfahrensständen.

Auf einem Siliziumsubstrat 1 vom n-Leitungstyp wird in einem Teilbereich ein dickes Oxid, in diesem Fall Feldoxid 2, aufgewachsen oder aufoxidiert und in einem daran angrenzenden Teilbereich ein Gateoxid 3 erzeugt. Diese Strukturierung wird mit dem LOCOS-Verfahren durchgeführt. Darauf wird eine erste Polysiliziumschicht abgeschieden, die anschließend strukturiert wird, so daß auf dem Feldoxid 2 Polysiliziumstrukturen 4, 5 und 6 erzeugt werden, aus denen ein Analogwiderstand, ein Dünnfilmtransistor und ein Kondensator gebildet werden. Auf dem Gateoxid 3 wird eine Struktur 7 erzeugt, die der Bildung eines Transistors dient. Mittels eines definierten Ofenschritts wird diese Polysiliziumebene in eine gute kristalline Struktur gebracht. Die Strukturen 4, 5, 6 und 7 werden alle aus derselben Polysiliziumlage erzeugt.

Die nächsten Schritte des Verfahrens werden unter Bezugnahme auf Figur 2 beschrieben, in der eine Lackmaske 8 dargestellt ist, die über den Siliziumstrukturen 4 und 5 erzeugt wird und als Maske bei der folgenden Implantation dient. Der Pfeil 9 deutet eine n+-Implantation an, mit der die Siliziumstrukturen 6 und 7 in n-dotierte Strukturen 6a und 7a überführt werden. Diese Fototechnik zur Erzeugung der dotierten Siliziumstruktur 6a, die als untere Kondensatorplatte dient, ist gegenüber einem Standardprozeß im wesentlichen der einzige Schritt, der ergänzt werden muß, um die komplette EEPROM-Zelle mit einem integrierten TFT (Dünnfilmtransistor) zu erhalten.

In Figur 3 wird deutlich, daß danach die Lackmaske 8 entfernt wird und zumindest im Bereich der Siliziumstrukturen 5, 6a und 7a ein Interpolydielektrikum 14, 15 und 16 prozessiert wird, welches aus einem Oxid besteht. Ein bei diesem Prozeß möglicherweise im Bereich der Struktur 4 prozessiertes Oxid stört im weiteren Gesamtprozeß nicht. Darauf wird eine zweite Polysiliziumschicht abgeschieden und strukturiert. Diese bildet die eigentliche Transistorpolyebene und wird im Bereich des Dünnfilmtransistors, also auf der Polysiliziumstruktur 5, in einem mittleren Bereich abgeschieden, so daß eine Polysiliziumstruktur 10 entsteht, die beidseitig beabstandet von den Rändern der Struktur 5 ausgebildet ist. Im Bereich des Kondensators wird die zweite Polysiliziumschicht in eine Struktur 11 gebracht, die mindestens einseitig einen Teil der unteren Struktur 6a freiläßt, so daß dort eine Anschlußfläche entsteht. Der obere Bereich der Struktur 11 bildet die zweite Anschlußfläche des Kondensators, dessen beide Flächen durch das Interpolydielektrikum 15 getrennt sind. Im Bereich des Transistors werden aus der zweiten Polysiliziumschicht Strukturen 12 und 13 gebildet, wobei die Struktur 12 im wesentlichen größenmäßig mit der darunter liegenden n+-dotierten Struktur 7a übereinstimmt.

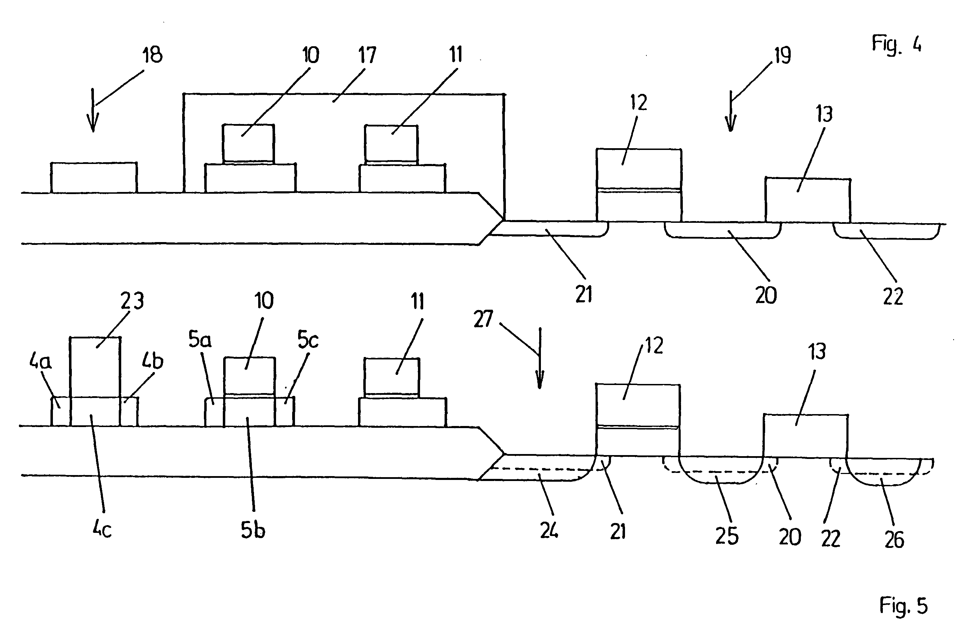

Die nächsten Verfahrensschritte sind in Figur 4 dargestellt. Im Bereich des Dünnfilmtransistors und des Kondensators, also über den Strukturen 10 und 11 der zweiten Polysiliziumebene, wird eine Lackmaske 17 erzeugt, die diesen Bereich gegenüber der folgenden LDD-Implantation mit Ionen oder Atomen von n-Leitungstyp schützt. Die Implantation ist durch die Pfeile 18 und 19 angedeutet. Dabei wird gleichzeitig die Siliziumstruktur 4 des Widerstands negativ dotiert und zwischen den Strukturen des Transistors 7a und 13 entstehen flache, diese Strukturen untergreifende, relativ schwach negativ dotierte LDD-Bereiche 20, 21 und 22.

Die abschließenden Verfahrensschritte sind in Figur 5 dargestellt. Die Lackmaske 17, die in Figur 4 dargestellt ist, wird zunächst entfernt und im mittleren Bereich der Siliziumstruktur 4 des Widerstands wird eine neue Lackmaske 23 erzeugt.

Sowohl die Lackmaske 17 als auch die für die Source/Drain-Implantation verwendete Lackmaske werden standardmäßig in einem CMOS-Prozeß verwendet. Weiterhin gibt es zudem eigene Fototechniken für eine p+-Implantation innerhalb der n-Wanne. Die p+-I²-Fototechnik ist zur klareren Darstellung grafisch nicht dargestellt. In diesem Fall wären die hier gezeigten Elemente mit Fotolack abgedeckt.

Danach wird eine durch den Pfeil 27 angedeutete Source/Drain-Implantation mit Ladungsträgern bzw. Atomen vom n-Leitungstyp durchgeführt. Dabei werden gleichzeitig n+-dotierte Bereiche 4a und 4b in dem Widerstand erzeugt, so daß im Endeffekt ein Widerstand mit den beiden außen liegenden n+-dotierten Bereichen 4a und 4b und dem dazwischen liegenden n-notierten Bereich 4c entsteht. In dem Dünnfilmtransistor werden durch die gleiche Implantation außen liegende n+-dotierte Bereiche 5a und 5c erzeugt, die den undotierten Bereich 5b umgeben, der unter der Struktur 10 der zweiten Polysiliziumschicht des Dünnfilmtransistors liegt. Außerdem werden bei der Source/ Drain-Implantation im Bereich des Transistors die n+-dotierten Wannen 24, 25 und 26 erzeugt, die im allgemeinen tiefer sind als die voher bei der LDD-Implantation erzeugten Diffusionsgebiete 20, 21 und 22. Man spricht hier auch von einer gleichzeitigen selbstjustierten Implantation der Source/ Drain-Kontakte des Dünnfilmtransistors und des konventionellen Transistors. Mit ein und derselben Implantation werden also die Anschlüsse für den Widerstand, die Drains des Dünnfilmtransistors und die n+-Drains des NMOS-Transistors implantiert. Für jede der drei in diesem Verfahren verwendeten Implantationen ist eine Fototechnik nötig.

## Patentansprüche

1. Verfahren zur Herstellung einer EEPROM-Halbleiterstruktur mit einem Widerstand, einem Dünnfilmtransistor, einem Kondensator, einem Speichertransistor und einem Transistor, bei dem
auf einem Halbleitersubstrat (1) vom ersten Leitungstyp in einem ersten Teilbereich eine Feldoxidschicht (2) und in einem zweiten Teilbereich ein Gateoxid (3) erzeugt wird,
durch Abscheidung einer ersten Polysiliziumschicht und anschließende Strukturierung auf dem Feldoxid (2) Siliziumstrukturen (4, 5 und 6) für den Widerstand, den Dünnfilmtransistor und den Kondensator und auf dem Gateoxid (3) eine Siliziumstruktur (7) für den Speichertransistor erzeugt werden,
die Siliziumstrukturen (4, 5) für den Widerstand und den Dünnfilmtransistor mit einer Maskenschicht (8) abgedeckt werden und die Siliziumstrukturen (6, 7) für den Kondensator und den Speichertransistor mit einem Dotierstoff vom zweiten Leitungstyp dotiert werden,
die Maskenschicht entfernt wird und im Bereich der Siliziumstrukturen (5, 6a und 7a) des Dünnfilmtransistors, des Kondensators und des Speichertransistors ein Interpolydielektrikum (14, 15 und 16) und darauf in einem weiteren Schritt Polysilizium abgeschieden und so strukturiert wird, daß
die Polysiliziumstruktur (10) auf der Siliziumstruktur des Dünnfilmtransistors beidseitig beabstandet von den Rändern der Siliziumstruktur des Dünnfilmtransistors ist,
die Polysiliziumstruktur (11) auf der Siliziumstruktur des Kondensators mindestens einseitig beabstandet von den Rändern der Siliziumstruktur des Kondensators ist,
die Polysiliziumstruktur (12) auf der Siliziumstruktur des Speichertransistors im Wesentlichen größenmäßig mit der Siliziumstruktur des Speichertransistors übereinstimmt und
eine weitere Siliziumstruktur (13) auf dem Gate-Oxid für den Transistor gebildet wird,
die Bereiche des Dünnfilmtransistors und des Kondensators mit einer weiteren Maskenschicht (17) abgedeckt werden und mit einer zweiten Implantation (18, 19) im Bereich des Speichertransistors und des Transistors eine LDD-Implantation durchgeführt wird und gleichzeitig die Siliziumstruktur (4) im Bereich des Widerstands dotiert wird,
die vorausgehend erzeugte weitere Maskenschicht entfernt wird, im mittleren Bereich (4c) des Widerstands eine neue Maske (23) erzeugt wird und eine dritte Implantation (27) zur Source/Drain-Implantation mit einem Dotierstoff vom zweiten Leitungstyp durchgeführt wird, wobei gleichzeitig die äußeren Bereiche (4a, 4b, 5a, 5c) der Siliziumstrukturen (4, 5) im Bereich des Widerstands und des Dünnfilmtransistors dotiert werden.

2. Verfahren nach Anspruch 1,
**dadurch gekennzeichnet,**
**daß** ein n-Typ-Halbleitersubstrat verwendet wird und die Implantationen mit Ionen oder Atomen vom p-Leitungstyp durchgeführt werden.

3. Verfahren nach Anspruch 1 oder 2,
**dadurch gekennzeichnet,**
**daß** die Dicken des Interpolydielektrikums und der ersten Polysiliziumschicht mit der LDD-Implantationsdosis abgestimmt werden.

4. Verfahren nach einem der vorhergehenden Ansprüche,
**dadurch gekennzeichnet,**
**daß** der Transistor in Form eines Dünnfilmtransistors hergestellt wird.

## Claims

1. Method for fabricating an EEPROM semiconductor structure having a resistor, a thin-film transistor, a capacitor, a memory transistor and a transistor, in which
on a semiconductor substrate (1) of the first conduction type, a field oxide layer (2) is produced in a first partial region and a gate oxide (3) is produced in a second partial region,
by the deposition of a first polysilicon layer and subsequent patterning, silicon structures (4, 5 and 6) for the resistor, the thin-film transistor and the capacitor are produced on the field oxide (2) and a silicon structure (7) for the memory transistor is produced on the gate oxide (3),
the silicon structures (4, 5) for the resistor and the thin-film transistor are covered with a mask layer (8) and the silicon structures (6, 7) for the capacitor and the memory transistor are doped with a dopant of the second conduction type,
the mask layer is removed and, in the region of the silicon structures (5, 6a and 7a) of the thin-film transistor, of the capacitor and of the memory transistor, an interpoly dielectric (14, 15 and 16) and on the latter, in a further step, polysilicon are deposited and patterned in such a way that
the polysilicon structure (10) on the silicon structure of the thin-film transistor is spaced apart from the edges of the silicon structure of the thin-film transistor on both sides,
the polysilicon structure (11) on the silicon structure of the capacitor is spaced apart from the edges of the silicon structure of the capacitor at least on one side,
the polysilicon structure (12) on the silicon structure of the memory transistor essentially corresponds in size to the silicon structure of the memory transistor, and
a further silicon structure (13) is formed on the gate oxide for the transistor,
the regions of the thin-film transistor and of the capacitor are covered with a further mask layer (17) and, with a second implantation (18, 19) in the region of the memory transistor and of the transistor, an LDD implantation is carried out and, at the same time, the silicon structure (4) in the region of the resistor is doped,
the previously produced further mask layer is removed, a new mask (23) is produced in the middle region (4c) of the resistor and a third implantation (27) for source/drain implantation with a dopant of the second conduction type is carried out, the outer regions (4a, 4b, 5a, 5c) of the silicon structures (4, 5) in the region of the resistor and of the thin-film transistor being doped at the same time.

2. Method according to Claim 1,
**characterized**
**in that** an n-type semiconductor substrate is used and the implantations are carried out with ions or atoms of the p conduction type.

3. Method according to Claim 1 or 2,
**characterized**
**in that** the thicknesses of the interpoly dielectric and of the first polysilicon layer are coordinated with the LDD implantation dose.

4. Method according to one of the preceding claims,
**characterized**
**in that** the transistor is fabricated in the form of a thin-film transistor.

## Revendications

1. Procédé de production d'une structure à semi-conducteur EEPROM comprenant une résistance, un transistor à couche mince, un condensateur, un transistor de mémoire et un transistor dans lequel :
- on produit sur un substrat (1) semi-conducteur du premier type de conductivité dans une première sous-région une couche (2) d'oxyde de champ et dans une deuxième sous-région un oxyde (3) de grille ;
- par dépôt d'une première couche de polysilicium et ensuite structuration, on produit sur l'oxyde (2) de champ des structures (4, 5 et 6) de silicium pour la résistance, pour le transistor à couche mince et pour le condensateur et sur l'oxyde (3) de grille, une structure (7) en silicium pour le transistor de mémoire ;
- on revêt les structures (4, 5) de silicium pour la résistance et pour le transistor à couche mince d'une couche (8) de masque et l'on dope les structures (6, 7) de silicium pour le condensateur et pour le transistor de mémoire à l'aide d'une substance de dopage du deuxième type de conductivité ;
- on élimine la couche de masque et dans la région des structures (5, 6a et 7a) en silicium du transistor à couche mince, du condensateur et du transistor de mémoire, on dépose et on structure un interpolydiélectrique (14, 15 et 16) et dessus dans un autre stade du polysilicium de façon que,
- la structure (10) en polysilicium sur la structure en silicium du transistor à couche mince soit à distance des deux côtés des bords de la structure en silicium du transistor à couche mince,
- la structure (11) en polysilicium sur la structure en silicium du condensateur soit à distance au moins d'un côté des bords de la structure en silicium du condensateur,
- la structure (12) en polysilicium sur la structure en silicium du transistor de mémoire coïncide essentiellement en grandeur avec la structure en silicium du transistor de mémoire et
- on forme une autre structure (13) en silicium sur l'oxyde de grille pour le transistor,
- on revêt les régions du transistor à couche mince du condensateur d'une autre couche (17) de masque et par une deuxième implantation (18, 19) on effectue dans la région du transistor de mémoire et du transistor une implantation LDD et on dope en même temps la structure (4) en silicium dans la région de la résistance,
- on élimine l'autre couche de masque produite précédemment, on produit dans la région (4c) médiane de la résistance un nouveau masque (23) et on effectue une troisième implantation (27) pour l'implantation de source/drain à l'aide d'une substance de dopage du deuxième type de conductivité en dopant simultanément la région (4a, 4b, 5a, 5c) extérieure des structures (4,5) en silicium dans la région de la résistance et du transistor en couche mince.

2. Procédé suivant la revendication 1, **caractérisé en ce qu'**il consiste à utiliser un substrat semi-conducteur de type n et à effectuer les implantations par des ions ou par des atomes du type de conductivité p.

3. Procédé suivant la revendication 1 ou 2, **caractérisé en ce qu'**il consiste à adapter les épaisseurs de l'interpolydiélectrique et de la première couche de polysilicium à la dose d'implantation LDD.

4. Procédé suivant l'une des revendications précédentes, **caractérisé en ce qu'**il consiste à fabriquer le transistor sous la forme d'un transistor à couche mince.
